Europäisches Patentamt

European Patent Office

Office européen des brevets

(19)

(11) Veröffentlichungsnummer: **0 086 853**
**B1**

(12) # EUROPÄISCHE PATENTSCHRIFT

(45) Veröffentlichungstag der Patentschrift:
08.01.86

(21) Anmeldenummer: 82101222.6

(22) Anmeldetag: 18.02.82

(51) Int. Cl.⁴: **H 04 B 1/10, H 04 B 15/00**

(54) Schaltungsanordnung zur Unterdrückung von Störsignalen.

(43) Veröffentlichungstag der Anmeldung:
**31.08.83 Patentblatt 83/35**

(45) Bekanntmachung des Hinweises auf die Patenterteilung:
**08.01.86 Patentblatt 86/2**

(84) Benannte Vertragsstaaten:
**AT FR GB IT NL SE**

(56) Entgegenhaltungen:
**CH - A - 601 947**
**DE - A - 2 943 913**
**DE - B - 2 618 532**

(73) Patentinhaber: **SABA GmbH,**
**Postfach 2060 Hermann-Schwer-Strasse 3,**
**D-7730 Villingen-Schwenningen (DE)**

(72) Erfinder: **Gleim, Günter, Terra 8, D-7730 VS-Marbach**
**(DE)**

ACTORUM AG

## Beschreibung

*Stand der Technik*

Die Erfindung bezieht sich auf eine Schaltungsanordnung zur Unterdrückung von Störsignalen bei der Übertragung von digitalen Signalen.

Es ist bekannt, die von einem Empfänger für derartige Signale empfangenen Signale in einem Vorverstärker zu verstärken. Die verstärkten Amplituden werden darauf mit Hilfe eines RC-Gliedes gespeichert, so dass sich an diesem ein den Amplituden entsprechender Analogwert bildet. Die diesen Analogwert überragenden Digitalsignale steuern eine nachfolgende Verstärkerstufe aus. Störimpulse, die unter dem gespeicherten Wert liegen, werden dabei unterdrückt. Wenn der Abstand der Nutzimpulse unterschiedlich ist, muss die Zeitkonstante des RC-Gliedes so ausgelegt sein, dass die Signale mit den kürzeren Abständen noch übertragen werden. Das hat aber zur Folge, dass der gespeicherte analoge Wert bei grösseren Impulsabständen des digitalen Signals so weit abgesunken ist, dass Störimpulse leichter durchkommen können, z.B. werden digitale Signale mit unterschiedlichen Abständen, d.h. pulscodemodulierte Signale, bei der Fernbedienung von Rundfunk- und Fernsehgeräten verwendet. Die mittels Infrarotlicht als Träger ausgesendeten Signale bestehen aus mehreren seriellen kurzen Impulsen, wobei die Information, d.h. welcher Kanal der Fernsehbedienung beeinflusst werden soll, in den verschiedenen Abständen zwischen den einzelnen Impulsen liegt. Es werden auf diese Weise digitale Worte aus mehreren Bits gebildet, wobei ein grosser Abstand z.B. ein H-Signal und ein kurzer Abstand ein L-Signal bildet.

Bei den bisher bekannten Schaltungskonzepten mit Fernsteuerung von Empfangsgeräten waren einzelne Störimpulse nicht sehr kritisch, weil Prüfschaltungen einen fehlerhaft empfangenen Befehl nicht akzeptierten. Anders sieht es in der Empfängertechnik aus, wenn diese mit Mikroprozessoren ausgestattet sind, wobei der Mikroprozessor durch sein Programm hintereinander die verschiedensten Steuerungen und Überwachungen vornimmt. wie z.B. Abfrage der Fernsteuerung, Anzeige des Displays, Abstimmung und Frequenzregelung usw. Das Programm des Mikroprozessorsystems ist derart erstellt, dass dieses die Fernsteuerbefehle bevorzugt behandelt. Es wird im Laufe des Programms immer wieder geprüft, ob ein Fernsteuerbefehl anliegt, andernfalls laufen dauernd andere Unterprogramme ab. Wenn nun starke Störimpulse vorhanden sind, wird laufend aufgerufen, so dass das Mikroprozessorsystem keine weiteren Aufgaben erfüllen kann.

In der DE-OS 2 943 913 wird eine Schaltungsanordnung beschrieben, die zum Empfang von impulsförmigen Lichtsignalen mittels optoelektronischer Wandlereinrichtungen dient. Dieser genannten Anmeldung liegt daher die Aufgabe zugrunde, Störlichtanteile insbesondere in Form von Gleichlicht zu eliminieren, in Abhängigkeit des Gleichlichtanteils eine variable Schwelle zu erzeugen, so dass nur die Nutzimpulse zur Auswertung gelangen. Dazu sind am Eingang der Schaltung verschiedene Zeitkonstantenglieder vorgesehen, von denen das eine nur bei niederfrequenten Signalanteilen eine Spannung erzeugt, höherfrequente Signale werden durch einen Kondensator kurzgeschlossen. Das andere Zeitkonstantenglied bildet für die niederfrequenten Signalanteile einen Kurzschluss. Das Verhältnis der durch die Zeitkonstantenglieder geteilten Spannungen ist frequenzabhängig und nicht abhängig von der Amplitude. Bei der dort offenbarten Schaltung wird der Schwellwert weitgehend vom niederfrequent modulierten Signalanteil des durch die Empfangsdioden fliessenden Stroms bestimmt, jedoch nicht durch die Höhe der Signalamplitude.

Ein anschliessender Komparator dient als Amplitudensieb mit einstellbarer Komparatorschwelle. Die Schwelle wird hier abhängig vom Störlichtanteil.

Der Erfindung liegt die Aufgabe zugrunde, bei der Schaltungsanordnung der im Oberbegriff des Patentanspruchs 1 definierten Art Störimpulse zu unterdrücken, wobei in Abhängigkeit von der Eingangsamplitude sowohl bei schwachen als auch bei starken Eingangssignalen Störimpulse unterdrückt werden, die insbesondere mikroprozessorgesteuerte Abstimmsysteme unbrauchbar machen.

Diese Aufgabe wird durch die im kennzeichnenden Teil des Patentanspruchs 1 angegebenen Merkmale gelöst.

*Beschreibung*

Zwecks Erläuterung der Erfindung soll diese mit Hilfe der Zeichnung an einem Beispiel beschrieben werden.

Fig. 1 zeigt die Verhältnisse der bisherigen Schaltungstechnik;

Fig. 2 zeigt Signalverläufe an den gekennzeichneten Schaltungspunkten;

Fig. 3 und 4 zeigen die entsprechenden Verhältnisse, die durch die Erfindung erzielt werden.

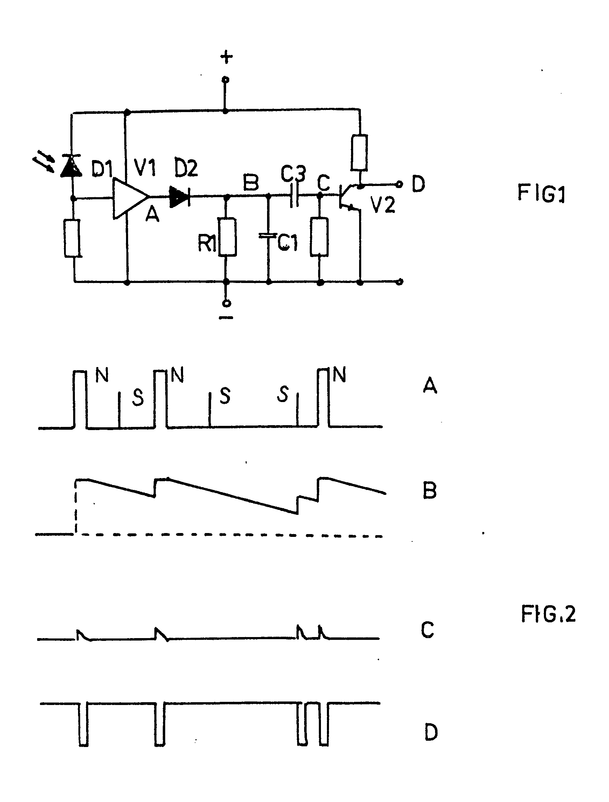

In Fig. 1 wird zunächst der Stand der Technik anhand von einem pulscodemodulierten Fernsteuersignal erläutert. Die Fernsteuersignale gelangen über die Empfängerdiode D1 an eine erste Verstärkerstufe V1. Am Ausgang A liegen die verstärkten Impulse des pulscodemodulierten Fernsteuersignals nach Fig. 2A. Diese werden mit Hilfe der Diode D2 gleichgerichtet und der Spitzenwert in einem RC-Glied R1C1 gespeichert. Es entsteht durch die Zeitkonstante R1C1 der Analogwert B nach Fig. 2B. Über den Koppelkondensator C3 gelangt die Differenz zwischen den Amplituden des Nutzsignals und dem gespeicherten Spitzenwert an die nächste Stufe V2. Die Impulsspitzen nach Fig. 2C steuern die nachfolgende Stufe V2. Am Ausgang D erscheint das Fernsteuersignal nach Fig. 2D.

Werden zum Nutzsignal N auch Störimpulse S empfangen, können letztere dann wirksam und schädlich werden, wenn sie die Analogspannung am Punkt B überragen. Dies ist insbesondere dann kritisch, wenn bei weiten Impulsabständen der Nutzsignale die Spannung am Punkt B so weit abgesunken ist, dass die Störimpulse S den Nutzimpulsen entsprechende Signale am Ausgang D verursachen.

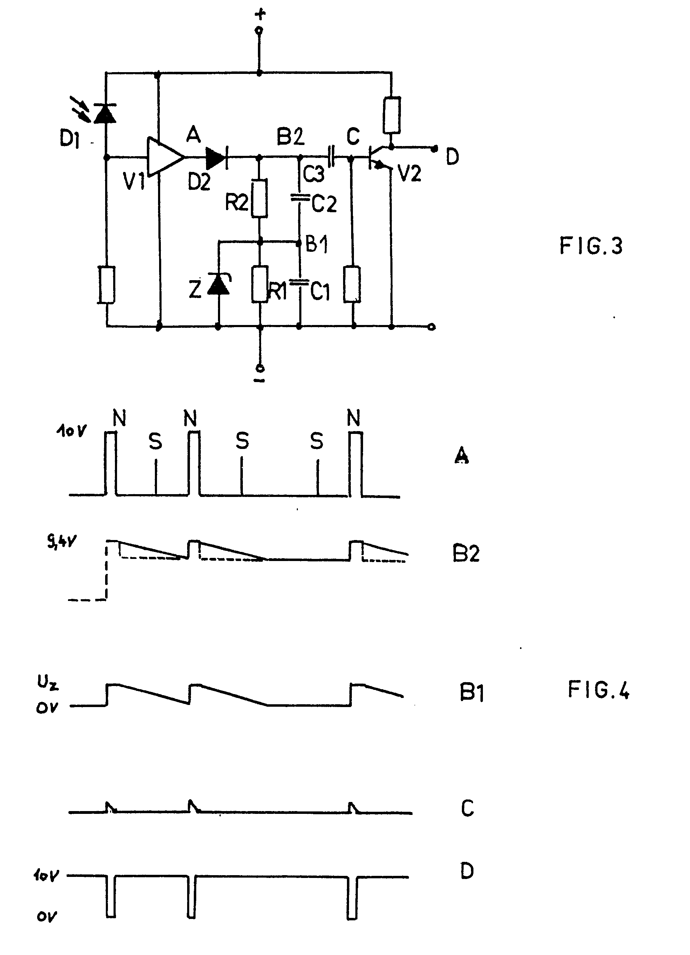

Zur Abhilfe dieses Mangels dient die Schaltung nach Fig. 3. Hierbei werden die der Fig. 1 entsprechenden Bauteile mit gleichen Bezugszeichen versehen. Im Gegensatz zu der zuvor beschriebenen Schaltung ist ein zusätzliches RC-Glied R2C2 eingefügt und dem ersten RC-Glied R1C1 ist eine spannungsbegrenzende Z-Diode parallelgeschaltet. Es ergeben sich an den Punkten A, B1, B2, C und D Spannungen nach Fig. 4 A-D. Die Zeitkonstante des RC-Gliedes R2C2 ist wesentlich höher als die des ersten RC-Gliedes R1C1. Die Spannungsbegrenzung am letzteren wird durch die Z-Diode Z so ausgelegt, dass eine Änderung um diesen Wert ausreicht, um die nachfolgende Stufe V2 eindeutig auszusteuern. Die Zeitkonstante R1C1 wird in bekannter Weise nach dem kürzesten Abstand der Nutzsignale bestimmt, während sich die Zeitkonstante R2C2 nach dem grössten Abstand der Nutzsignalimpulse richtet. Es kann sich hierbei auch um die grossen Pausen zwischen den einzelnen Impulspaketen, die die einzelnen digitalen Steuerworte bilden, handeln.

Wesentlich bei der beschriebenen Schaltungsanordnung ist, dass sich die in den Zeitkonstantengliedern R1, C1, R2, C2 gespeicherten Spannungen auf die Spitzenspannung des Nutzsignals beziehen. Hier wird die gespeicherte Spannung nur von den Nutzsignalen bestimmt. Das Verhältnis der in den Zeitkonstantengliedern R1/C1 und R2/C2 geteilten Spannungen ist bei sehr kleinen Amplituden abhängig von den Teilerverhältnissen R1:R2 bzw. C1:C2. Bei grösseren Amplituden wird die Begrenzung durch das Element Z wirksam. Die Spannung am Zeitkonstantenglied R1/C1 kann über den durch Z gegebenen begrenzten Wert nicht ansteigen, so dass der übrige Signalanteil an dem zweiten Zeitkonstantenglied R2/C2 abfällt.

Mit der soeben beschriebenen Schaltung ist eine sichere Unterdrückung von Störimpulsen gewährleistet, solange diese kleiner sind als das Nutzsignal abzüglich der maximal möglichen Spannung am ersten RC-Glied R1C1, bedingt durch das spannungsbegrenzende Mittel Z.

Die Schaltung arbeitet selbst dann einwanfrei, wenn die Zeitkonstante R1C1 durch Verwenden eines Kondensators mit einem sehr kleinen Wert extrem klein ist, was durch den gestrichelten Verlauf in Fig. 4 B2 angedeutet ist.

**Patentansprüche**

1. Schaltungsanordnung zur Unterdrückung von Störimpulsen bei der Übertragung von digitalen Signalen unterschiedlicher zeitlicher Abstände und unterschiedlicher Amplituden mit einem ersten Zeitkonstantenglied und einem in Reihe zu diesem geschalteten zweiten Zeitkonstantenglied, wobei die Zeitkonstantenglieder im Nutzsignalweg angeordnet sind, dadurch gekennzeichnet, dass die zwei Zeitkonstantenglieder (R1, C1; R2, C2) stark voneinander abweichende Zeitkonstanten besitzen, und dass dem ersten Zeitkonstantenglied (R1, C1) mit der kleineren Zeitkonstante ein spannungsbegrenzendes Mittel (Z) parallelgeschaltet ist, wobei sich das an den in Serie geschalteten Zeitkonstantengliedern (R1, C1; R2, C2) anliegende Signal an diesen derart aufteilt, dass das am ersten Zeitkonstantenglied (R1, C1) anliegende Signal zur Ansteuerung einer nachfolgenden Schalterstufe (V2) dient und dass das am zweiten Zeitkonstantenglied (R2, C2) anliegende Signal einen von der Amplitude des Nutzsignals (N) abhängigen Störabstand liefert, wobei der Spannungsanteil des Nutzsignals (N) am ersten Zeitkonstantenglied (R1, C1) mit der kleineren Zeitkonstante auf den durch das spannungsbegrenzende Mittel (Z) vorgegebenen Wert beschränkt ist, und dass das erste Zeitkonstantenglied (R1, C1) derart dimensioniert ist, dass die an diesem anliegende Spannung vor Eintreffen des nächsten Nutzimpulses (N) auf einen solchen Wert abgesunken ist, dass der Nutzimpuls (N) die nachfolgende als Schalter arbeitende Verstärkerstufe (V2) eindeutig durchschaltet.

2. Schaltungsanordnung nach Anspruch 1, dadurch gekennzeichnet, dass die Zeitkonstante des zweiten Zeitkonstantengliedes (R2, C2) nach dem grössten Abstand der Impulsfolge des Nutzsignals bemessen ist.

**Claims**

1. Circuit arrangement for the suppression of noise pulses in the transmission of digital signals of differing time intervals and differing amplitudes with a first constant member and a second time constant member connected in series with the first, whereby the time constant members are arranged in the useful signal path, characterized in that the two time constant members (R1, C1; R2, C2) possess considerably differing time constant values and in that a voltage limiting means (Z) is connected in parallel to the first time constant member (R1, C1) with the smaller time constant value, whereby the applied signal (N) is divided at the time constant members (C1, R1; C2, R2) connected in series in such a way, that the signal applied to the first time constant member (R1, C1) is used to control the following switching stage (V2) and that the signal applied to the second time constant member (R2, C2) supplies a signal to noise ratio depending on the amplitude of the useful signal, whereby the voltage portion of the useful signal (N) at the first time constant member (R1, C1) with the smaller time constant is limited to the value predetermined by the voltage limiting means (Z), and that the first time constant member (R1, C1) is dimensioned such, that the voltage applied thereto is reduced before arrival of the next useful pulse, (N) to such a value, that the useful pulse, (N) causes the following amplifier stage (V2), which works as a switch, to be switched positively to the conducting state.

2. Circuit arrangement according to claim 1, characterized in that the time constant of the second time constant member (R2, C2) is dimensined according to the largest pulse, separation of the useful signal.

**Revendications**

1. Circuit pour supprimer des signaux perturbateurs lors de la transmission de signaux numériques ayant des espacements temporels différents et des amplitudes différentes, comportant un premier composant d'établissement de constante de temps et un second composant d'établissement de constante de temps branché en série par rapport au premier, les composants d'établissement de constante de temps étant disposés dans la voie de transmission de signal utile, caractérisé en ce que les deux composants d'établissement de constante de temps (R1, C1; R2, C2) présentent des constantes de temps différant fortement lune de l'autre, en ce que le premier composant d'établissement de constante de temps (R1, C1) ayant la constante de temps la plus petite est branché en parallèle à un moyen de limitation de tension (Z), auquel cas le signal (N) appliqué aux composants d'établissement de constante de temps (R1, C1; R2, C2) branchés en série est divisé dans ceux-ci de telle sorte que le signal appliqué au premier composant d'établissement de constante de temps (R1, C1) serve à la commande de l'étage de commutation (V2) placé à la suite, en ce que le signal appliqué au second composant d'établissement de constante de temps (R2, C2) détermine un espacement qui est fonction de l'amplitude du signal utile, la fraction de tension du signal utile (N) appliquée au premier composant d'établissement de constante de temps (R1, C1) ayant la plus petite constante de temps étant limitée à la valeur prédéterminée par le moyen de limitation de tension (Z), et en ce que le premier composant d'établissement de constante de temps (R1, C1) est dimensionné de telle sorte que la tension qui lui est appliquée est réduite, avant l'arrivée de l'impulsion utile suivante (N), à une valeur telle que l'impulsion utile (N) commande de façon nette l'étage amplificateur (V2) placé à la suite et fonctionnant comme un commutateur.

2. Circuit selon la revendication 1, caractérisé en ce que la constante de temps du second composant détablissement de constante de temps (R2, C2) est définie en fonction du plus grand espacement de la séquence d'impulsions du signal utile.

FIG1

FIG.2

A

B

C

D

FIG.3

FIG.4